# EUROPEAN PATENT SPECIFICATION

(11) **EP 4 187 755 B1**
(45) Date of publication and mention of the grant of the patent: **03.04.2024**
(21) Application number: 21210681.9
(22) Date of filing: 26.11.2021
(51) Int. Cl.: H02J 50/20, H02J 50/80

(54) **DEVICES AND METHODS FOR TESTING OF FAR-FIELD WIRELESS CHARGING**
VORRICHTUNGEN UND VERFAHREN ZUM TESTEN DES DRAHTLOSEN FERNFELD-LADENS
DISPOSITIFS ET PROCÉDÉS DE TEST DE CHARGE SANS FIL EN CHAMP LOINTAIN

(43) Date of publication of application: 31.05.2023
(73) Proprietor: Rohde & Schwarz GmbH & Co. KG, 81671 München (DE)
(72) Inventor: Raddino, Daniela, 80469 München (DE); Morsi, Rania, Dr., 82008 Unterhaching (DE)
(74) Representative: Novagraaf Group

(56) References cited:
- US-A1- 2016 233 970
- US-A1- 2017 331 331
- US-A1- 2019 140 766
- US-A1- 2021 091 602
- US-B2- 11 139 699

## Description

### Technical Field

The present disclosure relates to testing of a variant of wireless charging involving far-field wireless power transfer, and in particular, to devices and methods for testing of such far-field wireless charging.

### Background Art

Ongoing power supply of wireless electronic devices typically involves repeated manual recharging or battery replacement. For a great deal of more recent wireless electronic devices, such an approach is impractical. This particularly applies to devices or chipsets for the Internet of Things (IoT).

The alternative of wireless charging has gained significant market momentum, especially for bridging a charging gap of up to several centimeters by near-field wireless charging charging variants involving capacitive coupling via electric fields or inductive coupling via magnetic fields. One example is us 2017/331331. A far-field charging variant, bridging up to several meters, is less widespread for its limited power transfer capacity, but still attracting interest in particular deployments of an abundance of devices which are difficult to access, for example.

When implementing far-field wireless charging, device manufacturers require the means to verify associated device capabilities and device conformity with applicable standards and regulation.

### Summary

In view of the above, the present disclosure aims to provide such testing means. This is achieved by the subject-matter defined by the appended independent claims. Preferred embodiments are set forth in the dependent claims and in the following description and drawings.

A first aspect of the present disclosure relates to a device for testing of far-field wireless charging. The device includes a first transceiver configured to conduct a far-field wireless power transfer between the device and a device under test (DUT); a second transceiver configured to conduct a data transfer between the device and the DUT; and a processor configured to establish a figure of merit of a wireless charging of the DUT in dependence of the power transfer and the data transfer.

The far-field wireless power transfer between the device and the DUT may exceed a Fraunhofer distance.

The first transceiver may further be configured for beamforming of the far-field wireless power transfer.

The second transceiver may include one of: a wireless transceiver; and a wired transceiver.

The data transfer may include one of: a receive power of the DUT due to the power transfer; a battery charge power of the DUT due to the power transfer; a battery DC level of the DUT; and a battery state of charge of the DUT.

The data transfer may include: a transmit power of the DUT due to the power transfer.

The figure of merit of the DUT may include one of: a compliance of the transmit power of the DUT with a preset transmit power at a preset frequency; and a charging efficiency of the DUT in dependence of the transmit power of the DUT.

The figure of merit of the DUT may include at least one of: a charging efficiency of the DUT over time; a charging efficiency of the DUT in dependence of a relative distance between the device and the DUT; a charging efficiency of the DUT in dependence of a relative orientation between the device and the DUT; a charging efficiency of the DUT in dependence of a relative motion between the device and the DUT; a charging efficiency of the DUT in dependence of a preset channel condition between the device and the DUT; a charging efficiency of the DUT in dependence of a simultaneous wireless data transfer of the first transceiver; a charging efficiency of the DUT in dependence of a simultaneous wireless transmission in a frequency range of the first transceiver; and a charging efficiency of the DUT in dependence of a waveform of the power transfer.

The relative orientation may include an angle of arrival, AoA, or an angle of departure, AoD, of the DUT.

The preset channel condition may include one or more of: a fading profile; an outdoor condition; and an indoor condition.

The processor may further be configured to trigger the simultaneous wireless transmission; and the simultaneous wireless transmission may include a Bluetooth, WiFi, cellular or ambient transmission.

A second aspect of the present disclosure relates to a method for testing of far-field wireless charging. The method includes: conducting a far-field wireless power transfer between the device and a DUT; conducting a data transfer between the device and the DUT; and establishing a figure of merit of a wireless charging of the DUT in dependence of the power transfer and the data transfer.

The method may be performed by a device for testing of far-field wireless charging as defined above.

### Advantageous Effects

The present disclosure provides devices and methods for testing of far-field wireless charging, which ensures proper operation of DUTs involved in the charging, and conformity of said DUTs with applicable standards and regulation.

Testing of a charge-receiving DUT may advantageously cover aspects such as:
- Charging quality of the DUT
- Charging while moving / rotating
- Coexistence testing
- Charging under different channel conditions
- Charging level over time
- Charging efficiency of the DUT for different transmit waveforms
- Charging range
- Simultaneous data reception or transmission while charging.

Testing of a charge-transmitting DUT may advantageously cover aspects such as:
- DUT transmitted directivity
- Charging support for multiple simultaneous receiver devices
- Charging support for multiple charging rates
- Power transfer efficiency of the transmitting DUT
- Charging efficiency in dependence of the transmitted waveform
- Simultaneously transmitting power & data
- Coexistence tests
- Standard compliance
- Regulatory testing

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIGs. 1 and 2: illustrate respective devices for testing of far-field wireless charging in accordance with the present disclosure;
- FIGs. 3 and 4: respectively illustrate testing subject to a relative orientation between the respective device and its DUT;
- FIG. 5: illustrates testing subject to preset channel conditions between the device and its DUT;
- FIG. 6: illustrates testing subject to a simultaneous wireless data transfer of the first transceiver and/or a simultaneous wireless transmission in a frequency range of the first transceiver; and
- FIG. 7: illustrates a method for testing of far-field wireless charging in accordance with the present disclosure.

### Detailed Descriptions of Drawings

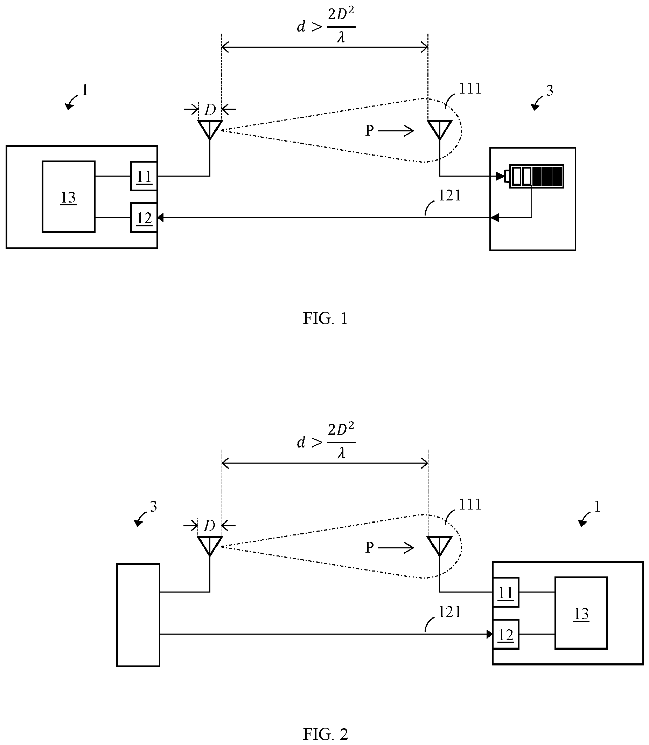

FIGs. 1 and 2 illustrate respective devices 1 for testing of far-field wireless charging in accordance with the present disclosure.

With reference to both FIG. 1 and FIG. 2, the respective device 1 includes a first transceiver 11 configured to conduct a far-field wireless power transfer 111, P between the device 1 and a device under test, DUT 3.

The far-field wireless power transfer 111, P between the device 1 and the DUT 3 may exceed a Fraunhofer distance of *d = 2D²*/*λ,* wherein *D* represents a largest dimension of a radiator (i.e., transmit antenna) involved in the power transfer 111, P, and λ is a wavelength of the radiated radio wave. The Fraunhofer distance defines the limit between the near field and the far field. The far field is characterized by propagating electromagnetic waves.

In particular, the first transceiver 11 may further be configured for beamforming of the far-field wireless power transfer 111, P. Beamforming or spatial filtering as used herein may refer to a signal processing technique used in antenna arrays for directional signal transmission or reception. Beamforming can be used at both the transmitting and receiving ends in order to achieve directivity (i.e., spatial selectivity). Those skilled in the art will readily appreciate that in the case of beamforming the individual antennas indicated in FIGs. 1 and 2 actually stand for antenna arrays. A directivity of the respective power transfer 111, P is indicated by a respective schematic main lobe.

The respective device 1 further includes a second transceiver 12 configured to conduct a data transfer 121 between the device 1 and the DUT 3.

The second transceiver 12 may include one of: a wireless transceiver (not shown); and a wired transceiver (see FIGs. 1 to 6).

For example, the data transfer 121 may be realized by means of a potentially standardized protocol. Alternatively, the data transfer 121 may be realized by direct measurement of the respective electric quantity of the DUT 3 by the device 1.

According to both FIG. 1 and FIG. 2, the data transfer 121 is directed towards the device 1. However, there may also be an optional data transfer (not shown) from the device 1 to the DUT 3. For example, this further data transfer may involve sending control signals needed for charging purposes, or sending communication signals to the DUT 3.

The respective device 1 further includes a processor 13 configured to establish a figure of merit of a wireless charging of the DUT 3 in dependence of the power transfer 111, P and the data transfer 121.

Upon testing of charge-receiving DUTs 3 (see FIG. 1), the data transfer 121 may include one of: a receive power of the DUT 3 due to the power transfer 111, P; a battery charge power of the DUT 3 due to the power transfer 111, P; a battery direct current (DC) level of the DUT 3; and a battery state of charge of the DUT 3. The established figure of merit of the DUT 3 may include a charging efficiency of the DUT 3 in dependence of a transmit (RF) power of the device 1 due to the power transfer 111, P.

As used herein, an efficiency may generally refer to a ratio of useful output to total input, and a charging efficiency may correspondingly refer to a ratio of an indication of charging output/achievement to an indication of charging input/effort.

As such, the figure of merit of the charge-receiving DUT 3 of FIG. 1 may include one of:
- a ratio of the receive power of the DUT 3 due to the power transfer 111 and the transmit RF power of the device 1,
- a ratio of the battery charge power (i.e., charging DC power) of the DUT 3 due to the power transfer 111 and the transmit RF power of the device 1,
- a ratio of an increase in the battery DC level (ΔV_{DC}) of the DUT 3 due to the power transfer 111 and the transmit RF power of the device 1, and
- a ratio of an increase in the battery state of charge (ΔSOC) of the DUT 3 due to the power transfer 111 and the transmit RF power of the device 1.

In other words, when testing the charge-receiving DUT 3 of FIG. 1, the overall charging efficiency may be calculated as a ratio of the charging DC power at the receiving DUT 3 and the transmit RF power at the transmitting device 1.

The overall charging efficiency may be determined as a product of an RF-to-RF efficiency over the air and an RF-to-DC efficiency of the DUT 3.

The RF-to-RF efficiency is a ratio of a received RF power at the receiving DUT 3 and a transmit RF power at the transmitting device 1, and may depend on a relative distance d between the device 1 and the DUT 3, or on a frequency of the power transfer 111, for example.

The RF-to-DC efficiency is a ratio of the charging DC power at the receiving DUT 3 and the received RF power at the receiving DUT 3, and may depend on an RF-to-DC conversion circuit of the DUT 3, or on a waveform (i.e., shape) of the power transfer 111, for example.

Upon testing of charge-transmitting DUTs 3 (see FIG. 2), the data transfer 121 may include: a transmit (RF) power of the DUT 3 due to the power transfer 111, P. The established figure of merit of the DUT 3 may include one of: a compliance of the transmit RF power of the DUT 3 with a preset transmit power at a preset frequency; and a charging efficiency of the DUT 3 in dependence of the transmit RF power of the DUT 3.

In other words, when testing the charge-transmitting DUT 3 of FIG. 2, then the overall charging efficiency may be calculated as a ratio between the charging DC power at the receiving device 1 and the transmit RF power of the transmitting DUT 3.

For example, the compliance of the transmit power of the DUT 3 with a preset transmit power at a preset frequency may be established by a frequency sweep through a spectral mask defining a preset transmit power at a respective preset frequency and verifying that the transmit power of the DUT 3 does not project beyond the spectral mask. The established figure of merit may correspond to a binary value indicating that the compliance test has (not) been passed successfully, for instance.

For example, the charging efficiency of the DUT 3 in dependence of the transmit power of the DUT 3 may be established by: dividing a receive power of the device 1 due to the power transfer 111, P by the communicated transmit power of the DUT 3 due to the power transfer 111, P.

Upon testing of charge-receiving DUTs 3 (see FIG. 1) or charge-transmitting DUTs 3 (see FIG. 2), the figure of merit of the DUT 3 may include at least one of: a charging efficiency of the DUT 3 over time; a charging efficiency of the DUT 3 in dependence of a relative distance d between the device 1 and the DUT 3; a charging efficiency of the DUT 3 in dependence of a relative orientation between the device 1 and the DUT 3; a charging efficiency of the DUT 3 in dependence of a relative motion between the device 1 and the DUT 3; a charging efficiency of the DUT 3 in dependence of a preset channel condition between the device 1 and the DUT 3; a charging efficiency of the DUT 3 in dependence of a simultaneous wireless data transfer of the first transceiver 11; a charging efficiency of the DUT 3 in dependence of a simultaneous wireless transmission 61 in a frequency range of the first transceiver 11; and a charging efficiency of the DUT 3 in dependence of the waveform of the power transfer 111.

For example, the charging efficiency of the DUT 3 over time may be established by recording individually established charging efficiency values as a function of the applicable recording time.

For example, the charging efficiency of the DUT 3 in dependence of a relative distance d between the device 1 and the DUT 3 may be established by recording individually established charging efficiency values as a function of the applicable relative distance d between the device 1 and the DUT 3.

For example, the charging efficiency of the DUT 3 in dependence of a relative motion between the device 1 and the DUT 3 may be established by recording individually established charging efficiency values as a function of the applicable relative motion (i.e., velocity, acceleration, rotation, ...) between the device 1 and the DUT 3.

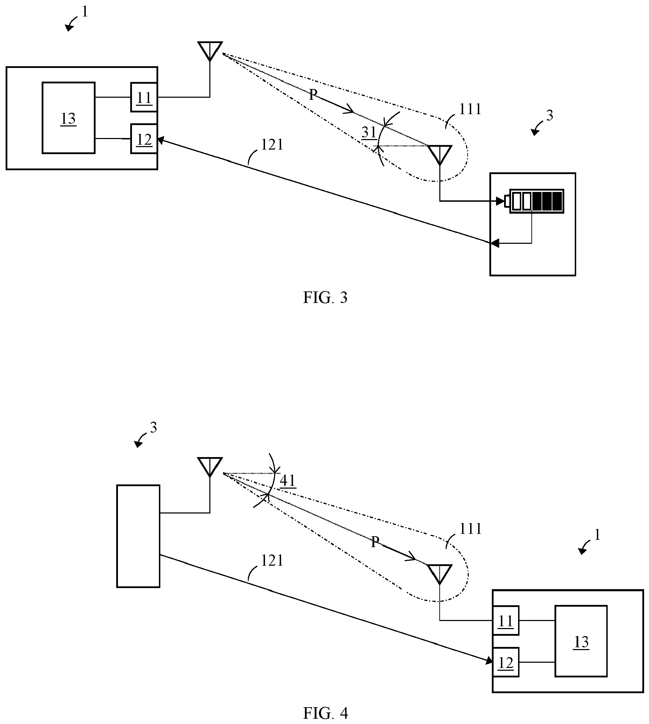

FIGs. 3 and 4 respectively illustrate testing subject to a relative orientation between the respective device 1 and its DUT 3.

For example, the charging efficiency of the DUT 3 in dependence of the relative orientation between the device 1 and the DUT 3 may be established by recording individually established charging efficiency values as a function of the applicable relative orientation between the device 1 and the DUT 3.

In particular, the relative orientation may include an angle of arrival, AoA 31 (see FIG. 3), or an angle of departure, AoD 41 (see FIG. 4), of the DUT 3.

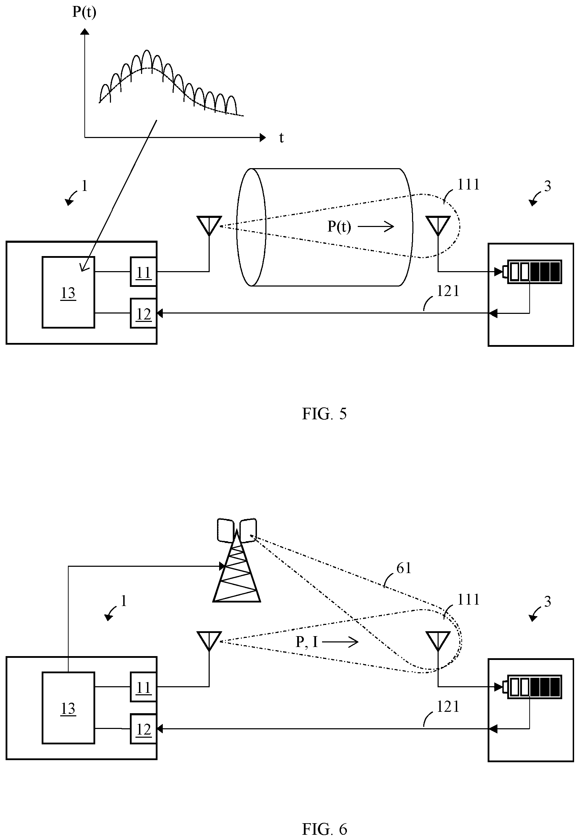

FIG. 5 illustrates testing subject to preset channel conditions between the device 1 and its DUT 3;

For example, the charging efficiency of the DUT 3 in dependence of a preset channel condition between the device 1 and the DUT 3 may be established by recording individually established charging efficiency values as a function of the applicable preset channel condition between the device 1 and the DUT 3.

In particular, the preset channel condition may include one or more of: a fading profile; an outdoor condition; and an indoor condition.

FIG. 5 shows that an exemplary fading profile P(t) may be used as the preset channel condition to which the power transfer 111, P between the device 1 and the DUT 3 may be subjected, resulting in a time-variant power transfer 111, P(t). As such, the processor 13 may further be configured to simulate an exposure of the power transfer 111, P(t) between the device 1 and the DUT 3 to the preset channel conditions.

FIG. 6 illustrates testing subject to a simultaneous wireless data transfer I of the first transceiver and a simultaneous wireless transmission 61 in a frequency range of the first transceiver.

In this connection, the processor 13 may further be configured to activate the simultaneous wireless data transfer I of the first transceiver 11.

For example, the charging efficiency of the DUT 3 in dependence of the simultaneous wireless data transfer I of the first transceiver 11 may be established by recording individually established charging efficiency values in a presence or an absence of the simultaneous wireless data transfer I and averaging the charging efficiency values recorded in a presence of the simultaneous wireless data transfer I to obtain the corresponding charging efficiency of the DUT 3. By further averaging the charging efficiency values recorded in an absence of the simultaneous wireless data transfer I and forming a ratio of the averaged charging efficiency values for both cases, a change in the charging efficiency of the DUT 3 in a presence of the simultaneous wireless data transfer I may be determined.

Similarly, the charging efficiency of the DUT 3 in dependence of the simultaneous wireless transmission 61 in a frequency range of the first transceiver 11 may be established by recording individually established charging efficiency values in a presence or an absence of the simultaneous wireless transmission 61.

To this end, the processor 13 may further be configured to trigger the simultaneous wireless transmission 61. In other words, the simultaneous wireless transmission 61 may be conducted by the device 1 or preferably by an external source of radiation. The simultaneous wireless transmission 61 may include a Bluetooth, WiFi, cellular or ambient transmission (e.g., noise floor). Without limitation, an exemplary simultaneous cellular transmission 61 is suggested in FIG. 6. Of note, additional considerations may be required for reproducibility of testing results, such as a preset transmit power, a preset relative distance, a preset relative orientation etc. between the external source of radiation and the DUT 3.

In general, considering interfering signals in a same frequency range of a transmit signal may have the following effects: On the one hand, an interfering signal may be disadvantageous to a *communication* signal making it more difficult at the receiver to extract the information from the communication signal. On the other hand, an interfering signal may advantageously add power on top of a transmitted power transfer 111.

The charging efficiency of the DUT 3 in dependence of the waveform (i.e., pulse shape) of the power transfer 111 may be established by recording individually established charging efficiency values at the DUT 3 for different waveforms (e.g., constant-envelope sinusoidal signal, multi-sine signals with different number of frequency tones, with different amplitude and phase for each tone, signals with different peak-to-average-power ratios, etc.).

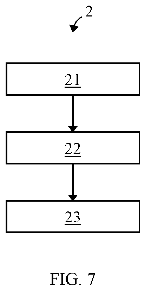

FIG. 7 illustrates a method 2 for testing of far-field wireless charging in accordance with the present disclosure.

The method 2 includes: conducting 21 a far-field wireless power transfer 111, P between the device 1 and a DUT 3; conducting 22 a data transfer 121 between the device 1 and the DUT 3; and establishing 23 a figure of merit of a wireless charging of the DUT 3 in dependence of the power transfer 111, P and the data transfer 121.

The method 2 may be performed by a device 1 for testing of far-field wireless charging as defined above.

## Claims

1. A device (1) for testing of far-field wireless charging, including
a first transceiver (11) configured to conduct a far-field wireless power transfer (111) between the device (1) and a device under test, DUT (3), the DUT (3) is connectable to the device (1) for a data transfer;
a second transceiver (12) configured to conduct a data transfer (121) between the device (1) and the DUT (3); and **characterised by** using a processor
a processor (13) configured to establish a figure of merit of a wireless charging of the DUT (3) in dependence of the power transfer (111) and the data transfer (121), the figure of merit is one of a compliance of the transmit power of the DUT with a preset transmit power at a preset frequency; and a charging efficiency of the DUT in dependence of the transmit power of the DUT.

2. The device (1) of claim 1,
the far-field wireless power transfer (111) between the device (1) and the DUT (3) exceeding a Fraunhofer distance.

3. The device (1) of claim 1 or claim 2,
the first transceiver (11) further configured for beamforming of the far-field wireless power transfer (111).

4. The device (1) of any one of the claims 1 to 3,
the second transceiver (12) including one of:
- a wireless transceiver; and
- a wired transceiver.

5. The device (1) of any one of the claims 1 to 4,
the data transfer (121) including one of:
- a receive power of the DUT (3) due to the power transfer (111);
- a battery charge power of the DUT (3) due to the power transfer (111);
- a battery DC level of the DUT (3); and
- a battery state of charge of the DUT (3).

6. The device (1) of any one of the claims 1 to 4,
the data transfer (121) including:
- a transmit power of the DUT (3) due to the power transfer (111).

7. The device (1) of claim 6,
the figure of merit of the DUT (3) including one of:
- a compliance of the transmit power of the DUT (3) with a preset transmit power at a preset frequency; and
- a charging efficiency of the DUT (3) in dependence of the transmit power of the DUT (3).

8. The device (1) of any one of the claims 5 to 7,
the figure of merit of the DUT (3) including at least one of:
- a charging efficiency of the DUT (3) over time;
- a charging efficiency of the DUT (3) in dependence of a relative distance (d) between the device (1) and the DUT (3);
- a charging efficiency of the DUT (3) in dependence of a relative orientation between the device (1) and the DUT (3);
- a charging efficiency of the DUT (3) in dependence of a relative motion between the device (1) and the DUT (3);
- a charging efficiency of the DUT (3) in dependence of a preset channel condition between the device (1) and the DUT (3);
- a charging efficiency of the DUT (3) in dependence of a simultaneous wireless data transfer of the first transceiver (11); and
- a charging efficiency of the DUT (3) in dependence of a simultaneous wireless transmission (61) in a frequency range of the first transceiver (11); and
- a charging efficiency of the DUT (3) in dependence of a waveform of the power transfer (111).

9. The device (1) of claim 8,
the relative orientation including an angle of arrival, AoA (31), or an angle of departure, AoD (41), of the DUT (3).

10. The device (1) of claim 8 or claim 9,
the preset channel condition including one or more of:
- a fading profile;
- an outdoor condition; and
- an indoor condition.

11. The device (1) of any one of the claims 8 to 10,
the processor further configured to trigger the simultaneous wireless transmission (61); the simultaneous wireless transmission (61) including a Bluetooth, WiFi, cellular or ambient transmission.

12. A method (2) for testing of far-field wireless charging, including
conducting (21) a far-field wireless power transfer (111) between the device (1) and a device under test, DUT (3), the DUT (3) is connectable to the device (1) for a data transfer;
conducting (22) a data transfer (121) between the device (1) and the DUT (3); and characteried by
establishing (23) a figure of merit of a wireless charging of the DUT (3) in dependence of the power transfer (111) and the data transfer (121), the figure of merit is one of a compliance of the transmit power of the DUT with a preset transmit power at a preset frequency; and a charging efficiency of the DUT in dependence of the transmit power of the DUT.

13. The method (2) of claim 12,
being performed by a device (1) for testing of far-field wireless charging of any one of the claims 1 to 11.

## Patentansprüche

1. Vorrichtung (1) zum Testen eines drahtlosen Fernfeldladens, die einschließt
einen ersten Transceiver (11), der konfiguriert ist, um eine drahtlose Fernfeldleistungsübertragung (111) zwischen der Vorrichtung (1) und einem Prüfling, DUT (3), auszuführen, wobei der DUT (3) für eine Datenübertragung mit der Vorrichtung (1) verbindbar ist;
einen zweiten Transceiver (12), der konfiguriert ist, um eine Datenübertragung (121) zwischen der Vorrichtung (1) und dem DUT (3) auszuführen; und **gekennzeichnet durch** ein Verwenden eines Prozessors
einen Prozessor (13), der konfiguriert ist, um eine Gütezahl eines drahtlosen Ladens des DUT (3) in Abhängigkeit von der Leistungsübertragung (111) und der Datenübertragung (121) einzurichten, wobei die Gütezahl eines ist von einer Übereinstimmung der Sendeleistung des DUT mit einer voreingestellten Sendeleistung bei einer voreingestellten Frequenz; und einer Ladeeffizienz des DUT in Abhängigkeit von der Sendeleistung des DUT.

2. Vorrichtung (1) nach Anspruch 1,
wobei die drahtlose Fernfeldleistungsübertragung (111) zwischen der Vorrichtung (1) und dem DUT (3) einen Fraunhofer-Abstand überschreitet.

3. Vorrichtung (1) nach Anspruch 1 oder 2,
wobei der erste Transceiver (11) ferner zum Strahlformen der drahtlosen Fernfeldleistungsübertragung (111) konfiguriert ist.

4. Vorrichtung (1) nach einem der Ansprüche 1 bis 3,
wobei der zweite Transceiver (12) eines einschließt von:
- einem drahtlosen Transceiver; und
- einem drahtgebundenen Transceiver.

5. Vorrichtung (1) nach einem der Ansprüche 1 bis 4,
wobei die Datenübertragung (121) eines einschließt von:
- einer Empfangsleistung des DUT (3) aufgrund der Leistungsübertragung (111);
- einer Batterieladeleistung des DUT (3) aufgrund der Leistungsübertragung (111);
- einem Batteriegleichstrompegel des DUT (3); und
- einem Batterieladezustand des DUT (3).

6. Vorrichtung (1) nach einem der Ansprüche 1 bis 4,
wobei die Datenübertragung (121) einschließt:
- eine Sendeleistung des DUT (3) aufgrund der Leistungsübertragung (111).

7. Vorrichtung (1) nach Anspruch 6,
wobei die Gütezahl des DUT (3) eines einschließt von:
- einer Übereinstimmung der Sendeleistung des DUT (3) mit einer voreingestellten Sendeleistung bei einer voreingestellten Frequenz; und
- einer Ladeeffizienz des DUT (3) in Abhängigkeit von der Sendeleistung des DUT (3).

8. Vorrichtung (1) nach einem der Ansprüche 5 bis 7,
wobei die Gütezahl des DUT (3) mindestens eines einschließt von:
- einer Ladeeffizienz des DUT (3) im Laufe der Zeit;
- einer Ladeeffizienz des DUT (3) in Abhängigkeit von einem relativen Abstand (d) zwischen der Vorrichtung (1) und dem DUT (3);
- einer Ladeeffizienz des DUT (3) in Abhängigkeit von einer relativen Ausrichtung zwischen der Vorrichtung (1) und dem DUT (3);
- einer Ladeeffizienz des DUT (3) in Abhängigkeit von einer relativen Bewegung zwischen der Vorrichtung (1) und dem DUT (3);
- einer Ladeeffizienz des DUT (3) in Abhängigkeit von einer voreingestellten Kanalbedingung zwischen der Vorrichtung (1) und dem DUT (3);
- einer Ladeeffizienz des DUT (3) in Abhängigkeit von einer gleichzeitigen drahtlosen Datenübertragung des ersten Transceivers (11); und
- einer Ladeeffizienz des DUT (3) in Abhängigkeit von einer gleichzeitigen drahtlosen Sendung (61) in einem Frequenzbereich des ersten Transceivers (11); und
- einer Ladeeffizienz des DUT (3) in Abhängigkeit von einer Wellenform der Leistungsübertragung (111).

9. Vorrichtung (1) nach Anspruch 8,
wobei die relative Ausrichtung einen Einfallswinkel, AoA (31) oder einen Abgangswinkel, AoD (41), des DUT (3) einschließt.

10. Vorrichtung (1) nach Anspruch 8 oder 9,
wobei die voreingestellte Kanalbedingung eines oder mehrere einschließt von:
- einem Ausblendprofil;
- einer Außenbedingung; und
- einer Innenbedingung.

11. Vorrichtung (1) nach einem der Ansprüche 8 bis 10,
wobei der Prozessor ferner konfiguriert ist, um die gleichzeitige drahtlose Sendung (61) auszulösen;
wobei die gleichzeitige drahtlose Sendung (61) eine Bluetooth-, WLAN-, zellulare oder Umgebungssendung einschließt.

12. Verfahren (2) zum Testen des drahtlosen Fernfeldladens, das einschließt
Ausführen (21) einer drahtlosen Fernfeldleistungsübertragung (111) zwischen der Vorrichtung (1) und einem Prüfling, DUT (3), wobei der DUT (3) mit der Vorrichtung (1) für eine Datenübertragung verbindbar ist;
Ausführen (22) einer Datenübertragung (121) zwischen der Vorrichtung (1) und dem DUT (3); und **gekennzeichnet durch**
Einrichten (23) einer Gütezahl eines drahtlosen Ladens des DUT (3) in Abhängigkeit von der Leistungsübertragung (111) und der Datenübertragung (121), wobei die Gütezahl eines ist von einer Übereinstimmung der Sendeleistung des DUT mit einer voreingestellten Sendeleistung bei einer voreingestellten Frequenz; und einer Ladeeffizienz des DUT in Abhängigkeit von der Sendeleistung des DUT.

13. Verfahren (2) nach Anspruch 12,
das durch eine Vorrichtung (1) zum Testen des drahtlosen Fernfeldladens nach einem der Ansprüche 1 bis 11 durchgeführt wird.

## Revendications

1. Dispositif (1) permettant de tester une recharge sans fil en champ lointain, comportant
un premier émetteur-récepteur (11) configuré pour conduire un transfert d'énergie sans fil en champ lointain (111) entre le dispositif (1) et un dispositif sous test, DUT (3), le DUT (3) pouvant être connecté au dispositif (1) pour un transfert de données ;
un second émetteur-récepteur (12) configuré pour conduire un transfert de données (121) entre le dispositif (1) et le DUT (3) ; et **caractérisé par** l'utilisation d'un processeur
un processeur (13) configuré pour établir un facteur de mérite d'une recharge sans fil du DUT (3) en fonction du transfert d'énergie (111) et du transfert de données (121), le facteur de mérite est l'un d'une conformité de la puissance de transmission du DUT avec une puissance de transmission prédéfinie à une fréquence prédéfinie ; et une efficacité de recharge du DUT en fonction de la puissance de transmission du DUT.

2. Dispositif (1) selon la revendication 1,
le transfert d'énergie sans fil en champ lointain (111) entre le dispositif (1) et le DUT (3) dépassant une distance Fraunhofer.

3. Dispositif (1) selon la revendication 1 ou la revendication 2,
le premier émetteur-récepteur (11) étant en outre configuré pour la formation de faisceau du transfert d'énergie sans fil en champ lointain (111).

4. Dispositif (1) selon l'une quelconque des revendications 1 à 3,
le second émetteur-récepteur (12) comportant l'un parmi :
- un émetteur-récepteur sans fil ; et
- un émetteur-récepteur câblé.

5. Dispositif (1) selon l'une quelconque des revendications 1 à 4,
le transfert de données (121) comportant l'un parmi :
- une puissance de réception du DUT (3) due au transfert d'énergie (111) ;
- une puissance de recharge de batterie du DUT (3) due au transfert d'énergie (111) ;
- un niveau de CC de batterie du DUT (3) ; et
- un état de recharge de batterie du DUT (3).

6. Dispositif (1) selon l'une quelconque des revendications 1 à 4,
le transfert de données (121) comportant :
- une puissance de transmission du DUT (3) due au transfert d'énergie (111).

7. Dispositif (1) selon la revendication 6,
le facteur de mérite du DUT (3) comportant l'un parmi :
- une conformité de la puissance de transmission du DUT (3) avec une puissance de transmission prédéfinie à une fréquence prédéfinie ; et
- une efficacité de recharge du DUT (3) en fonction de la puissance de transmission du DUT (3).

8. Dispositif (1) selon l'une quelconque des revendications 5 à 7,
le facteur de mérite du DUT (3) comportant au moins l'un parmi :
- une efficacité de recharge du DUT (3) au fil du temps ;
- une efficacité de recharge du DUT (3) en fonction d'une distance relative (d) entre le dispositif (1) et le DUT (3) ;
- une efficacité de recharge du DUT (3) en fonction d'une orientation relative entre le dispositif (1) et le DUT (3) ;
- une efficacité de recharge du DUT (3) en fonction d'un mouvement relatif entre le dispositif (1) et le DUT (3) ;
- une efficacité de recharge du DUT (3) en fonction d'une condition de canal prédéfinie entre le dispositif (1) et le DUT (3) ;
- une efficacité de recharge du DUT (3) en fonction d'un transfert de données sans fil simultané du premier émetteur-récepteur (11) ; et
- une efficacité de recharge du DUT (3) en fonction d'une transmission sans fil simultanée (61) dans une plage de fréquences du premier émetteur-récepteur (11) ; et
- une efficacité de recharge du DUT (3) en fonction d'une forme d'onde du transfert d'énergie (111).

9. Dispositif (1) selon la revendication 8,
l'orientation relative comportant un angle d'arrivée, AoA (31), ou un angle de départ, AoD (41), du DUT (3).

10. Dispositif (1) selon la revendication 8 ou la revendication 9,
la condition de canal prédéfinie comportant un ou plusieurs parmi :
- un profil d'évanouissement ;
- une condition extérieure ; et
- une condition intérieure.

11. Dispositif (1) selon l'une quelconque des revendications 8 à 10,
le processeur étant en outre configuré pour déclencher la transmission sans fil simultanée (61) ;
la transmission sans fil simultanée (61) comportant une transmission Bluetooth, WiFi, cellulaire ou ambiante.

12. Procédé (2) permettant de tester une recharge sans fil en champ lointain, comportant
la conduite (21) d'un transfert d'énergie sans fil en champ lointain (111) entre le dispositif (1) et un dispositif sous test, DUT (3), le DUT (3) pouvant être connecté au dispositif (1) pour un transfert de données ;
la conduite (22) d'un transfert de données (121) entre le dispositif (1) et le DUT (3) ; et **caractérisé par**
l'établissement (23) d'un facteur de mérite d'une recharge sans fil du DUT (3) en fonction du transfert d'énergie (111) et du transfert de données (121), le facteur de mérite est l'un d'une conformité de la puissance de transmission du DUT avec une puissance de transmission prédéfinie à une fréquence prédéfinie ; et une efficacité de recharge du DUT en fonction de la puissance de transmission du DUT.

13. Procédé (2) selon la revendication 12,
étant effectué par un dispositif (1) permettant de tester une recharge sans fil en champ lointain de l'une quelconque des revendications 1 à 11.
